# FASCICULE DE BREVET EUROPEEN

(11) **EP 4 528 806 B1**
(45) Date de publication et mention de la délivrance du brevet: **03.09.2025**
(21) Numéro de dépôt: 24200623.7
(22) Date de dépôt: 16.09.2024
(51) Int. Cl.: H01L 23/48, H01L 21/768, H01L 25/065

(54) **PUCE ELECTRONIQUE COMPRENANT DES PILIERS DE CONNEXION**
ELEKTRONISCHER CHIP MIT ANSCHLUSSSÄULEN
ELECTRONIC CHIP COMPRISING CONNECTION PILLARS

(30) Priorité: 25.09.2023 FR 2310130
(43) Date de publication de la demande: 26.03.2025
(73) Titulaire: STMicroelectronics International N.V., 1228 Plan-les-Ouates, Geneva (CH)
(72) Inventeur: BOUFNICHEL, Mohamed, 37380 MONNAIE (FR)
(74) Mandataire: Cabinet Beaumont

(56) Documents cités:
- US-A1- 2015 132 950
- US-A1- 2016 005 706
- US-A1- 2021 082 846

## Description

### Domaine technique

La présente description concerne le domaine de la connexion électrique entre une puce électronique et un boîtier ou entre deux puces électroniques, et concerne plus particulièrement des piliers de connexion de la puce électronique.

### Technique antérieure

Pour connecter une puce électronique à un élément extérieur, il peut être prévu des piliers ou plots de connexion situés sur une face de la puce électronique et connectés à des pistes conductrices de la puce électronique. Ainsi, il est possible de mettre en contact les piliers de connexion avec des zones ou des pistes conductrices situées sur un élément extérieur, par exemple un boîtier ou une autre puce électronique.

L'utilisation de piliers de connexion peut présenter certains inconvénients, notamment la fragilité des piliers de connexion lorsqu'ils sont de dimensions faibles ou lorsqu'ils présentent un rapport d'aspect élevé, le rapport d'aspect étant le rapport entre la hauteur et le diamètre du plot de connexion, la durée et le coût élevés du procédé de fabrication du plot de connexion lorsque le rapport d'aspect est élevé, et le risque d'arrachement des piliers de connexion de la face de la puce électronique sur laquelle ils sont formés. Le document US 2021/082846 décrit un circuit électronique comprenant des piliers conducteurs s'étendant dans un substrat semiconducteur.

### Résumé de l'invention

Le mode de réalisation pallie tout ou partie des inconvénients des puces électroniques comprenant des piliers de connexion connues.

Le mode de réalisation prévoit un circuit électronique comprenant un substrat semiconducteur ayant des première et deuxième faces opposées et des piliers conducteurs électriquement, destinés à être connectés à un élément extérieur au circuit électronique, s'étendant au travers du substrat semiconducteur de la deuxième face à la première face et se projetant en saillie depuis la première face.

le circuit électronique comprend, pour chaque pilier conducteur électriquement, une couche isolante électriquement située dans le substrat semiconducteur et entourant complètement le pilier conducteur électriquement dans le substrat semiconducteur.

Selon un mode de réalisation, le circuit électronique comprend une zone active s'étendant dans le substrat semiconducteur depuis la deuxième face et contenant au moins un composant électronique, chaque pilier conducteur électriquement comprenant en outre une piste de connexion s'étendant sur la deuxième face et connectée électriquement à la zone active.

Le circuit électronique comprend en outre au moins un mur isolant électriquement s'étendant au travers du substrat semiconducteur de la deuxième face à la première face et délimitant une portion semiconductrice du substrat semiconducteur contenant la zone active.

Selon un mode de réalisation, le mur isolant électriquement est séparé des couches isolantes électriquement entourant les piliers conducteurs électriquement par du matériau du substrat semiconducteur.

Les couches isolantes électriquement entourant les piliers conducteurs électriquement font partie du mur isolant électriquement.

Selon un mode de réalisation, chaque pilier conducteur électriquement se projette en saillie depuis la première face sur une hauteur supérieure à 25 µm.

Un mode de réalisation prévoit également un procédé de fabrication d'un circuit électronique tel que défini précédemment, comprenant, pour chaque pilier conducteur électriquement, la formation dans le substrat semiconducteur d'une première ouverture s'étendant dans le substrat semiconducteur depuis la deuxième face sur une partie de l'épaisseur du substrat semiconducteur, et le remplissage de la première ouverture par un matériau conducteur électriquement.

Selon un mode de réalisation, le procédé comprend une étape d'amincissement du substrat semiconducteur du côté de la première face pour que chaque pilier conducteur électriquement se projette en saillie depuis la première face.

Selon un mode de réalisation, le procédé comprend, avant le remplissage des premières ouvertures par le matériau conducteur électriquement, une étape de formation d'une couche isolante électriquement sur les parois de chaque première ouverture.

Selon un mode de réalisation, le procédé comprend la formation d'au moins une deuxième ouverture s'étendant dans le substrat semiconducteur depuis la deuxième face sur une partie de l'épaisseur du substrat semiconducteur, la deuxième ouverture étant moins profonde que les première ouvertures, et le remplissage complet de la deuxième ouverture par un matériau isolant électriquement.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un exemple d'une puce électronique ;
la figure 2 est une vue en coupe, partielle et schématique, d'un mode de réalisation d'une puce électronique ;
la figure 3, la figure 4, la figure 5, la figure 6, la figure 7, la figure 8, la figure 9, la figure 10, la figure 11, la figure 12, et la figure 13 sont chacune une vue en coupe, partielle et schématique, d'une structure obtenue à une étape d'un mode de réalisation d'un procédé de fabrication de la puce électronique représentée en figure 2 ;
la figure 14 est une vue en coupe, partielle et schématique, illustrant le dépôt de matériau conducteur d'un pilier de connexion de la puce électronique de la figure 1 ;
la figure 15 est une vue en coupe, partielle et schématique, illustrant le dépôt de matériau conducteur d'un pilier de connexion de la puce électronique de la figure 2 ;
la figure 16, la figure 17, la figure 18, et la figure 19 sont des vues en coupe de dessus, partielles et schématiques, de modes de réalisation de la puce électronique de la figure 2 à une étape du procédé de fabrication, les modes de réalisation illustrés sur les figures 16 et 18 ne faisant pas partie de l'invention ; et
la figure 20 est une vue en coupe, partielle et schématique, d'un mode de réalisation d'un circuit électronique.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près. En outre, on considère ici que les termes "isolant" et "conducteur" signifient respectivement "isolant électriquement" et "conducteur électriquement".

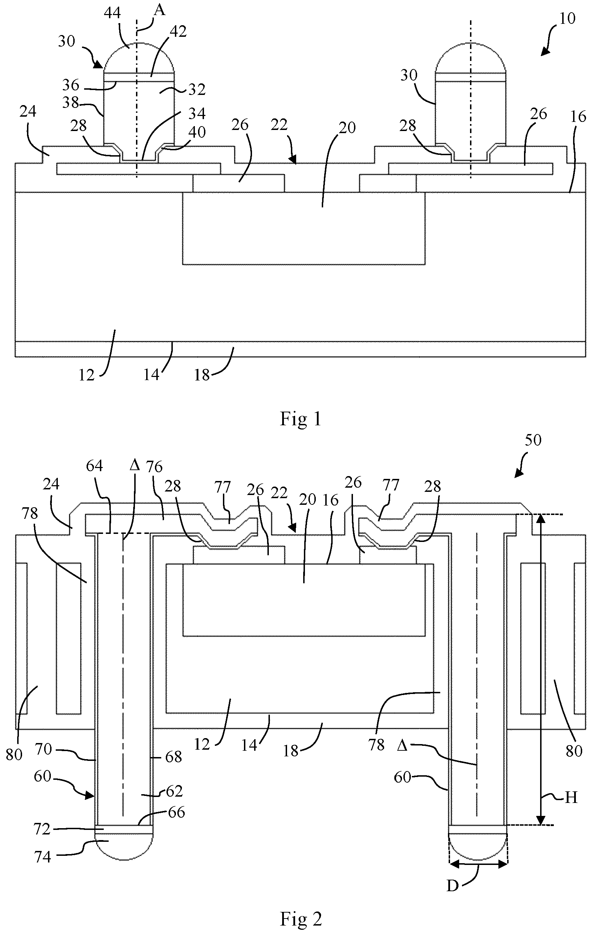

La figure 1 est une vue en coupe, partielle et schématique, d'un exemple d'une puce électronique 10.

La puce électronique 10 comprend :
- un substrat semiconducteur 12 comprenant une face inférieure 14 et une face supérieure 16 ;
- une couche isolante 18 recouvrant la face inférieure 14 ;
- une zone active 20 dans le substrat 12 affleurant à la face supérieure 16, un ou des composants électroniques, non représentés, étant formés dans et/ou sur la zone active 20 ;
- une structure d'interconnexion 22 recouvrant la face supérieure 16, comprenant un empilement de couches isolantes 24 et des pistes conductrices 26 dans et/ou entre les couches isolantes 24, certaines des pistes conductrices 26 étant au contact de la zone active 20 ;
- des ouvertures 28 dans l'empilement de couches isolantes 24 exposant chacune une partie de l'une des pistes conductrices 26 ; et
- des piliers ou plots de connexion 30, deux piliers de connexion étant représentés à titre d'exemple en figure 1, chaque pilier étant connecté à l'une des pistes conductrices 26.

Chaque pilier de connexion 30 comprend un tronc 32 qui s'étend selon un axe A sensiblement orthogonal à la face supérieure 16. Le tronc 32 comprend une base 34 du côté le plus proche du substrat 12, une face d'extrémité 36 opposée à la base 34 du côté le plus éloigné du substrat 12, et une paroi latérale 38 reliant la base 34 à la face d'extrémité 36. Le pilier de connexion 30 comprend en outre une couche d'interface 40 interposée entre la base 34 et la structure d'interconnexion 22. Le pilier 30 comprend, en outre, une couche de finition 42 recouvrant la face d'extrémité 36 et un bloc 44 d'un matériau de liaison recouvrant la couche de finition 42.

L'utilisation de piliers de connexion 30 tels que représentés en figure 1 peut présenter certains inconvénients. Les piliers de connexion 30 peuvent être fragiles lorsqu'ils sont de dimensions faibles ou lorsqu'ils présentent un rapport d'aspect, également appelé facteur de forme, élevé. En outre, chaque pilier de connexion 30 est lié mécaniquement à la structure d'interconnexion 22 seulement par la couche d'interface 40. Le procédé de fabrication du pilier de connexion 30 peut comprendre des étapes de gravure pouvant entraîner une gravure partielle de la couche d'interface 40 depuis sa périphérie. Ceci fragilise la liaison entre le tronc 32 et la structure d'interconnexion 22. On peut alors observer une augmentation du risque d'arrachement du pilier de connexion 30 de la structure de connexion 22. De plus, lorsque le tronc 32 du pilier de connexion 30 est en cuivre, le tronc 32 est généralement fabriqué par électrodéposition par dépôt de cuivre depuis la couche d'interface 34. Un inconvénient est alors la durée et le coût élevés du procédé de fabrication du plot de connexion 30 lorsque le rapport d'aspect du plot de connexion 30 est élevé.

La figure 2 est une vue en coupe, partielle et schématique, d'un exemple d'une puce électronique 50. La puce électronique 50 comprend l'ensemble des éléments de la puce électronique 10 de la figure 1 à la différence que les piliers de connexion 30 sont remplacés par des piliers ou plots de connexion 60.

Selon un mode de réalisation, chaque pilier de connexion 60 comprend :
- un tronc 62 qui s'étend selon un axe Δ sensiblement orthogonal à la face supérieure 16 et qui traverse le substrat 12 de la face supérieure 16 à la face inférieure 14 et se projette hors du substrat 12 depuis la face inférieure 14, le tronc 62 ayant une base 64 du côté le plus proche de la face supérieure 16 du substrat 12, une face d'extrémité 66 opposée à la base 64 du côté le plus proche de la face inférieure 14 du substrat 12, et une paroi latérale 68 reliant la base 64 à la face d'extrémité 66 ;
- une couche d'interface 70 recouvrant la paroi latérale 68 du tronc 62 et en contact physique direct avec la paroi latérale 68 ;
- une couche de finition 72 recouvrant la face d'extrémité 66 et en contact physique direct avec la face d'extrémité 66 ;
- un bloc 74 d'un matériau de liaison recouvrant la couche de finition 72 ;
- une piste de connexion 76 sur la structure d'interconnexion 22 et connectant la base 64 du tronc 62 à l'une des pistes conductrices 26 dans l'une des ouvertures 28, la couche d'interface 70 étant également présente entre la piste de connexion 76 et la structure d'interconnexion 22 ; et
- une couche isolante 77 recouvrant chaque piste de connexion 76.

La puce électronique 50 comprend en outre, pour chaque pilier 60, une couche isolante 78 située dans le substrat 12 et entourant le tronc 62 sur la totalité de la partie du tronc 62 s'étendant dans le substrat 12 et interposée entre le tronc 62 et le substrat 12. La couche isolante 78 s'étend dans le substrat 12 sur toute l'épaisseur du substrat 12, de la face inférieure 14 à la face supérieure 16. La couche isolante 78 est en contact physique direct avec la couche d'interface 70.

La puce électronique 50 comprend en outre un mur 80 d'isolation électrique latérale qui s'étend dans le substrat 12 sur toute l'épaisseur du substrat 12, de la face inférieure 14 à la face supérieure 16. Le mur 80 isole électriquement une partie du substrat 12 contenant la zone active 20 du reste du substrat 12.

Chaque pilier 60 est ancré dans le substrat 12 sur toute l'épaisseur du substrat 12. La tenue mécanique du pilier de connexion 60 est donc de façon avantageuse améliorée par rapport au pilier 30. En outre, le risque d'arrachement du pilier de connexion 60 est réduit.

Selon un mode de réalisation, le substrat 12 est en silicium (Si), en carbure de silicium (SiC), en composé III-V, notamment en nitrure de gallium (GaN), ou en composé II-VI. Le substrat 12 peut avoir une structure monocouche ou multicouches, par exemple une structure du type silicium sur isolant (SOI, sigle anglais pour Silicon On Insulator). A titre d'exemple, le substrat 12 peut comprendre une couche de GaN recouvrant un support en silicium. Selon un mode de réalisation, l'épaisseur du substrat 12 est comprise entre 50 µm et 300 µm.

Le tronc 62 peut avoir une forme sensiblement cylindrique d'axe Δ à base circulaire, carrée, rectangulaire, etc. Le diamètre moyen D du tronc 62 est compris entre 10 µm et 150 µm, le diamètre moyen correspondant au diamètre d'un tronc à base circulaire dont la surface est la même que celle du tronc 62. Selon un mode de réalisation, la face d'extrémité 66 est sensiblement perpendiculaire à l'axe Δ. Le tronc 62 et la piste de connexion 76 sont en métal, par exemple en cuivre, en nickel, en argent, en or, ou en un alliage de ces métaux. La hauteur totale H du tronc 62 depuis la face d'extrémité 66 jusqu'à la face supérieure de la piste de connexion 76 est comprise entre 75 µm et 400 µm. La hauteur du tronc 62 se projetant en saillie par rapport à la couche isolante 18 est comprise entre 25 µm et 100 µm. Le rapport d'aspect du tronc 62, qui correspond au rapport entre la hauteur totale H du tronc 62 et le diamètre moyen D du tronc 62, est compris entre 0,5 et 40.

Les pistes métalliques 26 sont par exemple en des matériaux choisis parmi le cuivre, un alliage de cuivre, le titane, un alliage de titane, le nitrure de titane, le platine, et un alliage de platine. Selon un mode de réalisation, l'épaisseur de chaque piste métallique 26 est comprise entre 0,5 µm et 1,5 µm.

Chaque couche isolante 18, 24, 77, 78 et chaque mur isolant 80 peut être en un matériau diélectrique, par exemple en oxyde de silicium (SiO₂), en nitrure de silicium (par exemple du Si₃N₄), en oxynitrure de silicium (par exemple du Si₂ON₂), ou en oxyde d'hafnium (HfO₂). Selon un mode de réalisation, l'épaisseur de la couche isolante 18 est comprise entre 0,1 µm et 0,5 µm. Selon un mode de réalisation, l'épaisseur de chaque couche isolante 24 est comprise entre 0,5 µm et 1,5 µm. Selon un mode de réalisation, l'épaisseur de la couche isolante 77 est comprise entre 0,5 µm et 1,5 µm. Selon un mode de réalisation, l'épaisseur de la couche isolante 78 est comprise entre 0,2 µm et 1 µm. Selon un mode de réalisation, l'épaisseur du mur 80 est comprise entre 1 µm et 3 µm.

L'épaisseur de la couche d'interface 70 est comprise entre 10 nm et 1 µm. La couche d'interface 70 joue le rôle d'amorce pour la formation du tronc 62 et de la piste de connexion 76 du pilier de connexion 60. La couche d'interface 70 peut comprendre une couche de titane ou de chrome, jouant le rôle de couche d'adhérence, et une couche de cuivre jouant le rôle de couche d'amorce pour la formation ultérieure du tronc 62 et de la piste de connexion 76.

L'épaisseur de la couche de finition 72 est comprise entre 10 nm et 5 µm, par exemple égale à 3 µm. La couche de finition 72 est en un matériau conducteur qui améliore l'adhésion du bloc 74. La couche de finition 72 est par exemple en métal, notamment en or ou en argent, et comprend éventuellement une ou des couches d'accroche et/ou une ou des couches barrière, comprenant par exemple du platine (Pt), du palladium (Pd), du nickel (Ni), du titane (Ti), du chrome (Cr), et/ou du tantale (Ta), entre le matériau du tronc 62 et le matériau du bloc 74 qui est déposée sur le tronc 62. La couche de finition 72 permet en outre d'éviter une oxydation de la face d'extrémité 66 du tronc 62 dans le cas où le procédé d'assemblage n'est pas réalisé sous atmosphère neutre ou réductrice.

Le matériau composant le bloc 74 dépend notamment du procédé d'assemblage mis en oeuvre pour la fixation de la puce électronique 50 à un autre élément. Le procédé d'assemblage peut notamment comprendre une étape de soudage ou une étape de frittage. Le matériau composant le bloc 74 peut comprendre une charge active comprenant des particules d'un matériau métallique, par exemple de l'argent, du cuivre, de l'étain, ou un alliage de ces métaux. La charge active peut en outre comprendre de l'or et d'autres additifs, par exemple des polymères et/ou des céramiques, ne participant pas à la fixation du pilier de connexion mais facilitant les procédés de mise en oeuvre du bloc 74. La hauteur du bloc 74, mesurée depuis la couche de finition 72 peut être d'environ 25 µm.

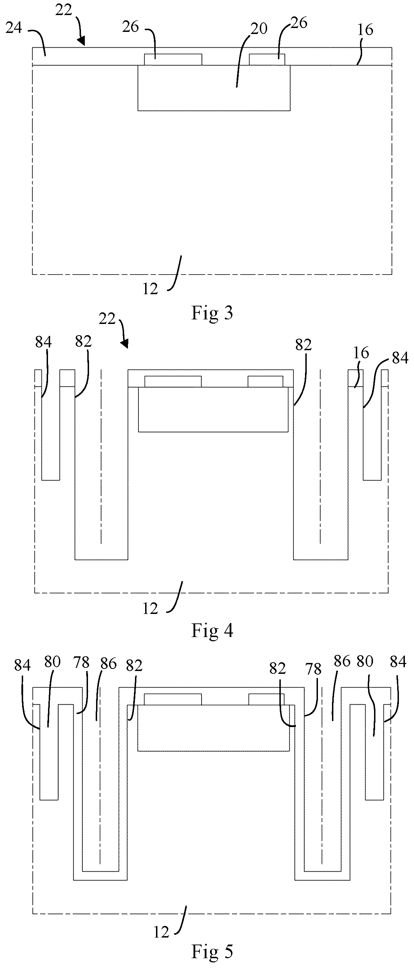

La figure 3, la figure 4, la figure 5, la figure 6, la figure 7, la figure 8, la figure 9, la figure 10, la figure 11, la figure 12, et la figure 13 sont chacune une vue en coupe, partielle et schématique, d'une structure obtenue à une étape d'un mode de réalisation d'un procédé de fabrication de la puce électronique 50 représentée en figure 2.

La figure 3 représente la structure obtenue après la formation de la zone active 20 et la formation de la structure d'interconnexion 22 sur la face supérieure 16 du substrat 12. Un ou des composants électroniques, non représentés, sont formés dans et/ou sur la zone active 20. Selon un mode de réalisation, à ce stade de la procédure, le substrat 12 correspond à une plaque, et les zones actives 20 de plusieurs puces électroniques sont formées dans et/ou sur le substrat 12, les zones actives 20 pouvant être identiques ou différentes. En figure 3, une seule zone active 20 est représentée et la structure d'interconnexion 22 comprend deux pistes conductrices 26 connectées à la zone active 20 et une couche isolante 24 recouvrant les pistes conductrices 26 et la face supérieure 16 du substrat 12 autour des pistes conductrices 26. A ce stade du procédé, l'épaisseur du substrat 12 est supérieure à l'épaisseur finale souhaitée du substrat 12. L'épaisseur du substrat 12 à ce stade du procédé peut être comprise entre 500 µm et 1,3 mm.

La figure 4 représente la structure obtenue après la formation d'une ouverture 82 à l'emplacement souhaité de chaque pilier de connexion 60 et la formation d'une ouverture 84 à l'emplacement souhaitée de chaque mur 80. Les ouvertures 82 et 84 traversent complètement la structure d'interconnexion 22 et s'étendent sur une partie de l'épaisseur du substrat 12 depuis la face supérieure 16. Les ouvertures 82 ont la même profondeur et les ouvertures 84 ont la même profondeur. La profondeur des ouvertures 82 est supérieure à la profondeur des ouvertures 84. Selon un mode de réalisation, la profondeur des ouvertures 84 est sensiblement égale à l'épaisseur finale souhaitée du substrat 12. La profondeur des ouvertures 84 peut être comprise entre 50 µm et 300 µm. Selon un mode de réalisation, les ouvertures 82 et 84 sont réalisées par des étapes de gravure ionique réactive profonde (DRIE sigle anglais pour Deep Reactive Ion Etching). Selon le procédé utilisé pour la formations des ouvertures 82 et 84, les ouvertures 82 et les ouvertures 84 peuvent être réalisées simultanément ou peuvent être réalisées à des étapes séparées. En particulier, avec une gravure ionique réactive profonde, la vitesse de gravure dépend du diamètre de l'ouverture de sorte que les ouvertures 84 qui ont une largeur inférieure au diamètre moyen des ouvertures 82 peuvent être réalisées simultanément aux ouvertures 82.

La figure 5 représente la structure obtenue après la formation de la couche isolante 78 dans chaque ouverture 82 et la formation du mur isolant 80 dans chaque ouverture 84. A ce stade du procédé, la couche isolante 78 recouvre les parois latérales et le fond de l'ouverture 82. Cette étape peut comprendre le dépôt d'une couche isolante simultanément sur les parois de l'ouverture 84 et sur les parois de l'ouverture 82, l'épaisseur de la couche isolante étant telle qu'elle remplit complètement l'ouverture 84 mais ne remplit pas complètement chaque ouverture 82 de sorte qu'une cavité 86 est présente dans chaque ouverture 82 après la formation de la couche isolante.

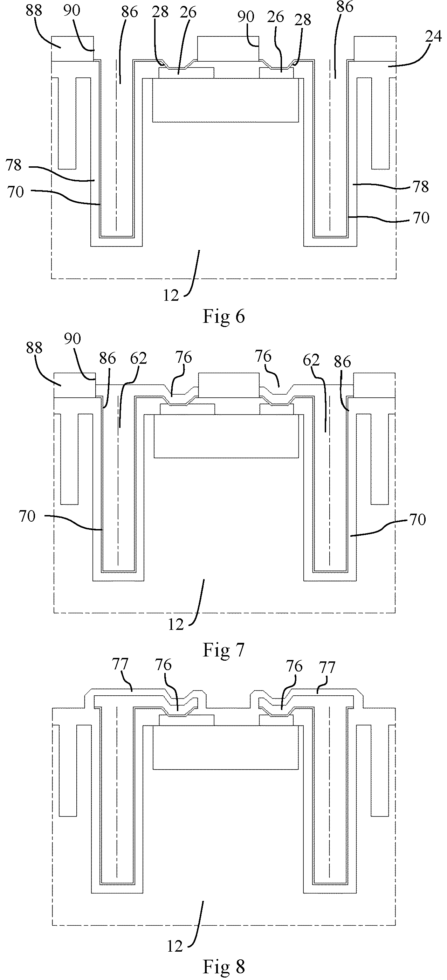

La figure 6 représente la structure obtenue après la formation, pour chaque pilier de connexion à réaliser, de l'ouverture 28 dans la couche isolante 24 pour exposer l'une des pistes conductrices 26, le dépôt d'un masque 88 sur la couche isolante 24 comprenant, pour chaque pilier de connexion à réaliser, une ouverture 90 exposant la cavité 86, l'ouverture 28 et la partie de la couche isolante 24 reliant la cavité 86 à l'ouverture 28, et la formation de la couche d'interface 70 dans chaque ouverture 90. A ce stade du procédé, la couche d'interface 70 recouvre toutes les parois de la cavité 86, notamment les parois latérales et le fond de la cavité 86, les parois de l'ouverture 28, et la partie exposée de la couche isolante 24 reliant la cavité 86 à l'ouverture 28 correspondante. Le masque 88 peut correspondre à un film qui est appliqué sur la couche isolante 24.

La figure 7 représente la structure obtenue après, pour chaque pilier de connexion à réaliser, du remplissage complet de chaque cavité 86 d'un matériau conducteur, formant ainsi le tronc 62 du pilier de connexion, et la formation de la portion de connexion 76 de chaque pilier de connexion. Le matériau conducteur composant le tronc 62 peut être déposé par électrodéposition sur la couche d'interface 70. Dans ce cas, le dépôt du matériau conducteur est réalisé à partir de la couche d'interface 70 selon une direction sensiblement perpendiculaire à la couche d'interface 70. Ceci permet de façon avantageuse de remplir la cavité 86 même si le facteur de forme de la cavité 86, c'est-à-dire le rapport entre la hauteur de la cavité et le diamètre de la cavité est élevé, puisque le dépôt du matériau conducteur est réalisé notamment depuis les parois latérales de la cavité 86.

La figure 8 représente la structure obtenue après le retrait du film 88 et la formation, pour chaque pilier de connexion, de la couche isolante 77 recouvrant la piste de connexion 76.

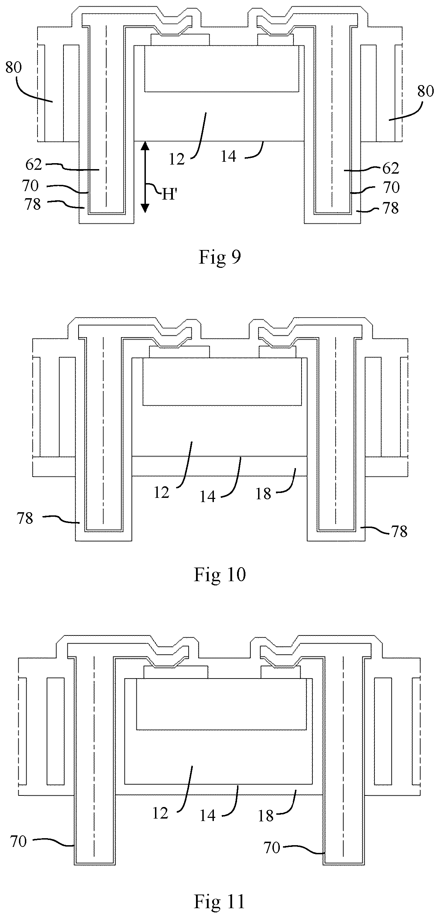

La figure 9 représente la structure obtenue après une gravure du substrat 12 depuis la face inférieure 14 du substrat 12. A la fin de l'étape de gravure, pour chaque pilier de connexion, une partie du tronc 62, entouré de la couche d'interface 70 et de la couche isolante 78, se projette en saillie du substrat 12 depuis la face inférieure 14 sur une hauteur H'. L'étape de gravure peut comprendre une gravure chimique sélective par rapport au matériau composant la couche isolante 78. Selon un mode de réalisation, la gravure du substrat 12 est arrêtée lorsque l'extrémité du mur 80 affleure sur la face inférieure 14. La hauteur H' est fixée par l'étape de gravure.

La figure 10 représente la structure obtenue après la formation de la couche isolante 18 sur la face inférieure 14 du substrat 12. Selon un mode de réalisation, la couche isolante 18 est composée du même matériau que la couche isolante 78 et l'épaisseur de la couche isolante 18, à cette étape du procédé, est sensiblement égale à la somme de l'épaisseur de la couche isolante 78 et de l'épaisseur finale souhaitée de la couche isolante 18, par exemple égale au double de l'épaisseur de la couche isolante 78.

La figure 11 représente la structure obtenue après la gravure complète de la portion de la couche isolante 78 qui est exposée du côté de la face inférieure 14 du substrat 12. Cette étape peut en outre entraîner la gravure de la couche isolante 18 sur l'épaisseur de la couche isolante 78. La couche isolante 18 ayant l'épaisseur finale souhaitée est alors obtenue.

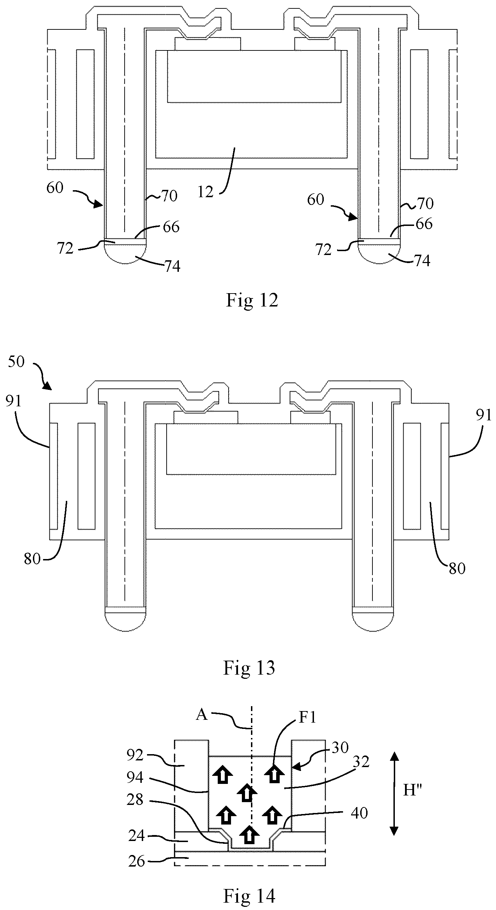

La figure 12 représente la structure obtenue après, pour chaque pilier de connexion 60, la gravure de la couche d'interface 70 recouvrant la face d'extrémité 66, la formation de la couche de finition 72 et la formation du bloc 74 du matériau de liaison.

La figure 13 représente la structure obtenue après une étape de découpe pour séparer les puces électroniques 50. Selon un mode de réalisation, les lignes de découpe 91 sont situées entre les murs 80 de puces électroniques 50 adjacentes.

Chaque puce électronique 50 ainsi individualisée peut alors être fixée à un élément extérieur, par exemple un boîtier ou une autre puce électronique. Le mur 80 protège la zone active 20 de la puce électronique 50 notamment contre des décharges électrostatiques au niveau des parois latérales de la puce électronique 50 lors de la manipulation et la fixation de la puce électronique 50 à l'élément extérieur.

La figure 14 est une vue en coupe, partielle et schématique, illustrant la formation d'un pilier de connexion 30 de la puce électronique de la figure 1. La figure 14 représente la structure obtenue après le dépôt d'un masque 92 sur la structure d'interconnexion 22 comprenant, pour chaque pilier de connexion à réaliser, une ouverture 94 exposant l'ouverture 28, la formation de la couche d'interface 40 sur la partie de la structure d'interconnexion 22 exposée dans l'ouverture 94, et le dépôt du matériau conducteur pour former le tronc 32 du pilier de connexion. Le matériau conducteur composant le tronc 32 peut être déposé par électrodéposition sur la couche d'interface 70. Dans ce cas, le dépôt du matériau conducteur est réalisé à partir de la couche d'interface 70 selon une direction sensiblement perpendiculaire à la couche d'interface 70, comme cela est illustré par les flèches F1 parallèles à l'axe A du tronc 32. Pour former le tronc 32, il faut ainsi déposer le matériau conducteur sensiblement sur une hauteur H" mesurée selon l'axe A. La précision sur la hauteur H" du tronc 62 pouvant être atteinte dépend essentiellement de la précision pouvant être atteinte avec le procédé d'électrodéposition.

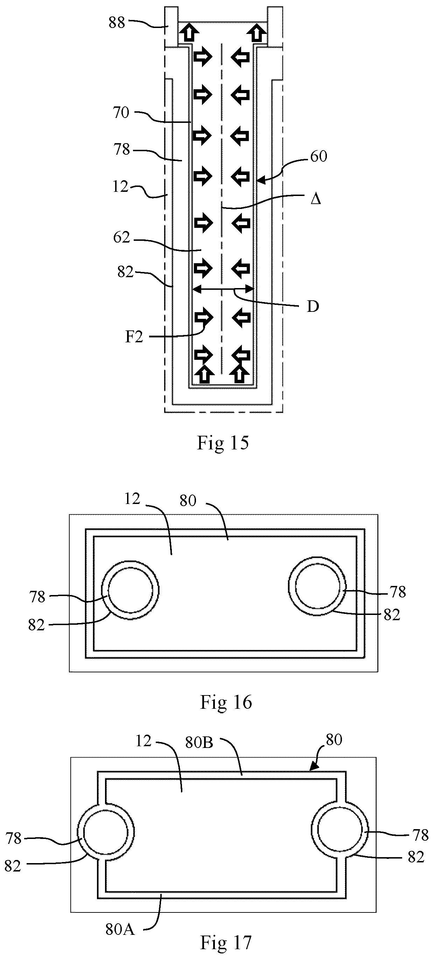

La figure 15 est une vue en coupe, partielle et schématique, illustrant la formation d'un pilier de connexion 60 de la puce électronique de la figure 2 correspondant à l'étape décrite précédemment en relation avec la figure 7. Le matériau conducteur composant le tronc 62 peut être déposé par électrodéposition sur la couche d'interface 70. Dans ce cas, le dépôt du matériau conducteur est réalisé à partir de la couche d'interface 70 selon une direction sensiblement perpendiculaire à la couche d'interface 70 comme cela est illustré par les flèches F2. Pour former le tronc 62, il faut ainsi déposer le matériau conducteur sensiblement sur une épaisseur égale à la moitié du diamètre moyen D du tronc 62. La durée de l'étape de formation du tronc 62 est donc sensiblement indépendante de la hauteur totale du tronc 62, et également de la hauteur du tronc 62 qui, sur la puce électronique une fois finie, se trouve en saillie du côté de la face inférieure 14 du substrat 12. En effet, cette hauteur est définie par l'étape d'amincissement du substrat 12 décrite précédemment en relation avec la figure 9. Comme la moitié du diamètre moyen D du tronc 62 est inférieure à la hauteur H" indiquée en figure 14, la durée de l'étape de formation du tronc 62 par électrodéposition peut de façon avantageuse être réduite par rapport à la durée de formation du tronc 32.

La précision sur la hauteur H du tronc 62 pouvant être atteinte dépend essentiellement de la précision pouvant être atteinte par le procédé de gravure mis en oeuvre pour former l'ouverture 82. De façon avantageuse, la précision pouvant être atteinte sur la hauteur H du tronc 62 est supérieure à la précision pouvant être atteinte sur la hauteur H" du tronc 32. En outre, la précision pouvant être atteinte sur la hauteur de la partie du tronc 62 en saillie du côté de la face inférieure 16 dépend essentiellement de la précision pouvant être atteinte par le procédé de gravure mis en oeuvre pour former l'ouverture 82 et la précision pouvant être atteinte par le procédé mis en oeuvre pour l'amincissement du substrat 12. De façon avantageuse, la précision pouvant être atteinte sur la hauteur de la partie du tronc 62 en saillie du côté de la face inférieure 16 est supérieure à la précision pouvant être atteinte sur la hauteur H" du tronc 32. L'homogénéité des hauteurs des parties en saillie des piliers de connexion 60 est améliorée.

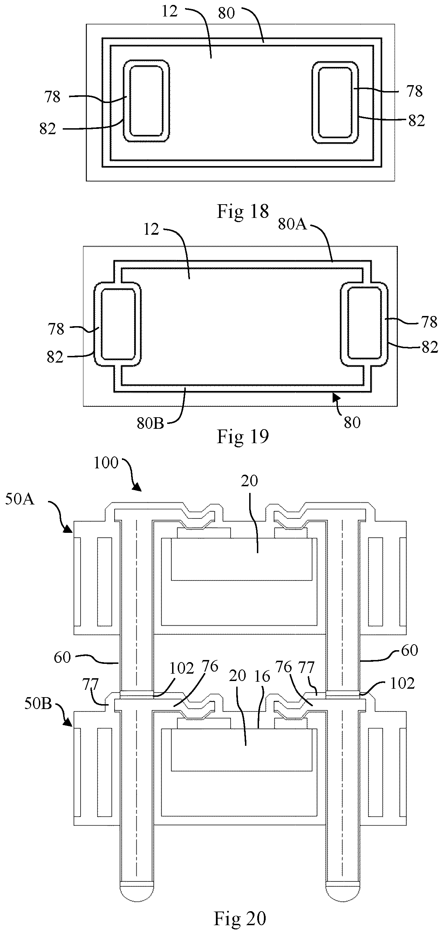

La figure 16, la figure 17, la figure 18, et la figure 19 sont chacune une vue en coupe de dessus, partielle et schématique, des structures obtenues à l'étape décrite précédemment en relation avec la figure 5 pour différents modes de réalisation de la puce électronique de la figure 2. Pour les figures 16 à 19, le plan de coupe est situé entre la face inférieure 14 et la face supérieure 16 du substrat 12 et est parallèle à la face supérieure 16. Les modes de réalisation illustrés sur les figures 16 et 18 ne font pas partie de l'invention.

Sur les figures 16 et 17, les ouvertures 82 sont à section droite circulaire. Sur les figures 18 et 19, les ouvertures 82 sont à section rectangulaire à coins arrondis.

Sur les figures 16 et 18, le mur 80 est séparé de chaque couche isolante 78 par une portion du substrat 12 et entoure les deux ouvertures 82. Sur les figures 17 et 19, le mur 80 comprend deux sous-murs 80A et 80B, chaque sous-mur 80A et 80B rejoignant à ses extrémités la couche isolante 78 destinée à entourer un pilier de connexion. Les couches isolantes 78 destinées à entourer les piliers de connexion font alors partie du mur 80.

De façon avantageuse, selon le mode de réalisation décrit précédemment en relation avec les figures 3 à 13, le mur 80 est formé simultanément aux ouvertures 82 et aux couches isolantes 78. Il n'y a donc pas d'étapes supplémentaires à prévoir pour la formation du mur 80.

La figure 20 est une vue en coupe, partielle et schématique, d'un mode de réalisation d'un circuit électronique 100.

Le circuit électronique 100 comprend un empilement de deux puces électroniques 50A et 50B ayant chacune la structure illustrée en figure 2. Les zones actives 20 des puces électroniques 50A et 50B peuvent contenir des composants électroniques différents et/ou agencés différemment. Les plots de connexion 60 de la puce électronique 50A sont fixés à la puce électronique 50B du côté de la face supérieure 16 de la puce électronique 50B. En figure 20, les plots de connexion 60 de la puce électronique 50A sont fixés aux pistes de connexion 76 de la puce électronique 50B au travers d'ouvertures 102 prévues dans la couche isolante 77 recouvrant les pistes de connexion 76 de la puce électronique 50B.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Circuit électronique (50) comprenant :
- un substrat semiconducteur (12) ayant des première et deuxième faces (14, 16) opposées ;
- des piliers conducteurs électriquement (60), destinés à être connectés à un élément extérieur au circuit électronique, s'étendant au travers du substrat semiconducteur (12) de la deuxième face (16) à la première face (14) et se projetant en saillie depuis la première face (14) ;
- pour chaque pilier conducteur électriquement (60), une couche isolante électriquement (78) située dans le substrat semiconducteur (12) et entourant complètement le pilier conducteur électriquement dans le substrat semiconducteur (12) ; et
- au moins un mur isolant électriquement (80) s'étendant au travers du substrat semiconducteur (12) de la deuxième face (16) à la première face (14) et délimitant une portion semiconductrice du substrat semiconducteur (12) contenant la zone active (20),
**caractérisé en ce que** les couches isolantes électriquement (78) entourant les piliers conducteurs électriquement (60) font partie du mur isolant électriquement (80).

2. Circuit électronique selon la revendication 1, comprenant une zone active (20) s'étendant dans le substrat semiconducteur (12) depuis la deuxième face (16) et contenant au moins un composant électronique, chaque pilier conducteur électriquement (60) comprenant en outre une piste de connexion (76) s'étendant sur la deuxième face (16) et connectée électriquement à la zone active (20).

3. Circuit électronique selon la revendication 1 ou 2, dans lequel chaque pilier conducteur électriquement (60) se projette en saillie depuis la première face (14) sur une hauteur supérieure à 25 µm.

4. Procédé de fabrication d'un circuit électronique (60) selon la revendication 1, comprenant, pour chaque pilier conducteur électriquement (60), la formation dans le substrat semiconducteur (12) d'une première ouverture (82) s'étendant dans le substrat semiconducteur (12) depuis la deuxième face (16) sur une partie de l'épaisseur du substrat semiconducteur (12), et le remplissage de la première ouverture (82) par un matériau conducteur électriquement.

5. Procédé selon la revendication 4, comprenant une étape d'amincissement du substrat semiconducteur (12) du côté de la première face (14) pour que chaque pilier conducteur électriquement (60) se projette en saillie depuis la première face (14).

6. Procédé selon la revendication 4 ou 5, comprenant, avant le remplissage des premières ouvertures (82) par le matériau conducteur électriquement, une étape de formation d'une couche isolante électriquement (78) sur les parois de chaque première ouverture (82).

7. Procédé selon l'une quelconque des revendications 4 à 6, comprenant la formation d'au moins une deuxième ouverture (84) s'étendant dans le substrat semiconducteur (12) depuis la deuxième face (16) sur une partie de l'épaisseur du substrat semiconducteur (12), la deuxième ouverture (84) étant moins profonde que les première ouvertures (82), et le remplissage complet de la deuxième ouverture (84) par un matériau isolant électriquement.

## Patentansprüche

1. Eine elektronische Schaltung (50), die Folgendes aufweist:
- ein Halbleitersubstrat (12) mit einer ersten und einer zweiten gegenüberliegenden Fläche (14, 16);
- elektrisch leitfähige Säulen (60), die dazu bestimmt sind, mit einem Element außerhalb der elektronischen Schaltung verbunden zu werden, sich durch das Halbleitersubstrat (12) von der zweiten Fläche (16) zur ersten Fläche (14) erstrecken und aus der ersten Fläche (14) herausragen;
- für jede elektrisch leitfähige Säule (60), eine elektrisch isolierende Schicht (78), die sich im Halbleitersubstrat (12) befindet und die elektrisch leitfähige Säule im Halbleitersubstrat (12) vollständig umgibt;
- wenigstens eine elektrisch isolierende Wand (80), die sich durch das Halbleitersubstrat (12) von der zweiten Fläche (16) zur ersten Fläche (14) erstreckt und einen Halbleiterabschnitt des Halbleitersubstrats (12) begrenzt, der den aktiven Bereich (20) enthält,
**dadurch gekennzeichnet, dass** die elektrisch isolierenden Schichten (78), die die elektrisch leitenden Säulen (60) umgeben, Teil der elektrisch isolierenden Wand (80) sind.

2. Die elektronische Schaltung nach Anspruch 1, aufweisend einen aktiven Bereich (20), der sich von der zweiten Fläche (16) in das Halbleitersubstrat (12) erstreckt und wenigstens ein elektronisches Bauteil enthält, wobei jede elektrisch leitende Säule (60) ferner eine Verbindungsbahn (76) aufweist, die sich über die zweite Fläche (16) erstreckt und elektrisch mit dem aktiven Bereich (20) verbunden ist.

3. Die elektronische Schaltung nach Anspruch 1 oder 2, wobei jede elektrisch leitfähige Säule (60) von der ersten Fläche (14) um mehr als 25 µm hervorsteht.

4. Ein Verfahren zur Herstellung einer elektronischen Schaltung (60) nach Anspruch 1, das für jede elektrisch leitfähige Säule (60) die folgenden Schritte aufweist: Ausbilden, in dem Halbleitersubstrat (12), einer ersten Öffnung (82), die sich von der zweiten Fläche (16) über einen Teil der Dicke des Halbleitersubstrats (12) in das Halbleitersubstrat (12) erstreckt, und
Füllen der ersten Öffnung (82) mit einem elektrisch leitfähigen Material.

5. Das Verfahren nach Anspruch 4, aufweisend einen Schritt des Ausdünnens des Halbleitersubstrats (12) auf der Seite der ersten Fläche (14), so dass jede elektrisch leitfähige Säule (60) von der ersten Fläche (14) vorsteht.

6. Das Verfahren nach Anspruch 4 oder 5, aufweisend, vor dem Füllen der ersten Öffnungen (82) mit dem elektrisch leitfähigen Material, einen Schritt des Ausbildens einer elektrisch isolierenden Schicht (78) auf den Wänden jeder ersten Öffnung (82).

7. Das Verfahren nach einem der Ansprüche 4 bis 6, aufweisend Ausbilden wenigstens einer zweiten Öffnung (84), die sich von der zweiten Fläche (16) über einen Teil der Dicke des Halbleitersubstrats (12) in das Halbleitersubstrat (12) erstreckt, wobei die zweite Öffnung (84) flacher ist als die ersten Öffnungen (82), und vollständiges Füllen der zweiten Öffnung (84) mit elektrisch isolierendem Material.

## Claims

1. An electronic circuit (50) comprising:
- a semiconductor substrate (12) having opposed first and second faces (14, 16);
- electrically conductive pillars (60), intended to be connected to an element external to the electronic circuit, extending through the semiconductor substrate (12) from the second face (16) to the first face (14) and projecting from the first face (14);
- for each electrically conductive pillar (60), an electrically insulating layer (78) located in the semiconductor substrate (12) and completely surrounding the electrically conductive pillar in the semiconductor substrate (12);
- at least one electrically insulating wall (80) extending through the semiconductor substrate (12) from the second face (16) to the first face (14), and delimiting a semiconductor portion of the semiconductor substrate (12) containing the active area (20),
**characterized in that** the electrically insulating layers (78) surrounding the electrically conductive pillars (60) are part of the electrically insulating wall (80)

2. The electronic circuit according to claim 1, comprising an active area (20) extending into the semiconductor substrate (12) from the second face (16) and including at least one electronic component, each electrically conductive pillar (60) further comprising a connection track (76) extending over the second face (16) and electrically connected to the active area (20).

3. The electronic circuit according to claim 1 or 2, wherein each electrically conductive pillar (60) projects from the first face (14) to a height greater than 25 µm.

4. A method of manufacturing an electronic circuit (60) according to claim 1, comprising, for each electrically conductive pillar (60), forming in the semiconductor substrate (12) a first opening (82) extending into the semiconductor substrate (12) from the second face (16) over a part of the thickness of the semiconductor substrate (12), and filling the first opening (82) with an electrically conductive material.

5. The method according to claim 4, comprising a step of thinning the semiconductor substrate (12) on the side of the first face (14) so that each electrically conductive pillar (60) projects from the first face (14).

6. The method according to claim 4 or 5, comprising, prior to filling the first openings (82) with the electrically conductive material, a step of forming an electrically insulating layer (78) on the walls of each first opening (82).

7. The method according to any one of claims 4 to 6, comprising forming at least one second opening (84) extending into the semiconductor substrate (12) from the second face (16) over part of the thickness of the semiconductor substrate (12), the second opening (84) being shallower than the first openings (82), and completely filling the second opening (84) with electrically insulating material.
